# EUROPÄISCHE PATENTANMELDUNG

(11) **EP 0 961 149 A2**
(43) Veröffentlichungstag der Anmeldung: **01.12.1999**
(21) Anmeldenummer: 99109008.5
(22) Anmeldetag: 06.05.1999
(51) Int. Cl.: G02B 17/08, G03F 7/20, G02B 27/00

(54) **Katadioptrisches Projektionsobjektiv mit adaptivem Spiegel und Projektionsbelichtungsverfahren**

(30) Priorität: 29.05.1998 DE 19824030
(71) Anmelder: Carl Zeiss, 89518 Heidenheim (Brenz) (DE); CARL-ZEISS-STIFTUNG, trading as CARL ZEISS, 89518 Heidenheim (DE)
(72) Erfinder: Wagner, Christian, Dr., 73430 Aalen (DE); Gerhard, Michael, Dr., 73432 Aalen (DE); Richter, Gerald, 73453 Abtsgmünd (DE)

(57) **Zusammenfassung**

Katadioptrisches Projektionsobjektiv der Mikrolithographie mit mindestens einem gekrümmten Spiegel (S2), wobei
- mindestens ein gekrümmter Spiegel (S2) verformbar ist
- Stellelemente (Ai, 41) vorgesehen sind, welche den verformbaren Spiegel (S2) verformen können
- die Stellelemente (Ai, 41) an bestimmte Bildfehler und deren Korrektur angepaßt sind.

Geeignet für Astigmatismus, Vierwelligkeit bedingt durch Lens Heating, Compaction u.a..

## Beschreibung

Die Erfindung betrifft ein katadioptrisches Projektionsobjektiv der Mikrolithographie mit mindestens einem gekrümmten Spiegel und ein Betriebsverfahren für ein solches Objektiv.

Die US 5,142,132 beschreibt einen Wafer-Stepper mit gattungsgemäßem Objektiv und einem Planspiegel, der zur Korrektur optischer Fehler durch ein x/y-Array von Aktuatoren deformiert werden kann. Eine möglichst große Zahl von Aktuatoren für jeweils einen möglichst kleinen Teil des Spiegels wird als vorteilhaft beschrieben. Der verstellbare Spiegel wird unter großem Reflexwinkel betrieben, so daß seine Wirkungen stark asymmetrisch sind.

Projektionsobjektive der Mikrolithographie mit lageveränderlichen Elementen (z-Trieb) oder Veränderung des optischen Weges durch Änderung von Druck oder Zusammensetzung des Füllgases sind in verschiedenen Varianten mit vielerlei Regelkreisen bekannt. Hier sind allerdings regelmäßig reine refraktive Objektive beschrieben.

EP 0 660 169 A1 gibt ein refraktives Projektionsobjektiv der Mikrolithographie mit Korrektur nicht rotationssymmetrischer Fehler durch Rotation von zylindrischen Linsen an. Auch sind Zitate zu längsverschieblichen Linsen angegeben.

Katadioptrische Projektionsobjektive mit einem gekrümmten Spiegel und Polarisationsstrahlteiler sind z.B. aus DE 196 16 922.4 und den darin angegebenen Zitaten bekannt. Der Inhalt jener Patentanmeldung soll auch Teil dieser Anmeldung sein.

Andere katadioptrische Projektionsobjektive sind ebenfalls bekannt, z.B. solche vom Typ des abgewandelten Schupman-Achromaten, auch H-Design genannt und z.B. in US 5,052,763 beschrieben.

Aufgabe der Erfindung ist die Bereitstellung eines katadioptrischen Reduktionsobjektivs, das bei möglichst einfacher Konstruktion doch eine effektive Steuerung und Regelung der Abbildungsqualität besonders hinsichtlich veränderlicher Störungen erlaubt. Entsprechende Betriebsverfahren für eine Projektionsbelichtungsanlage sollen angegeben werden.

Gelöst wird diese Aufgabe durch ein katadioptrisches Projektionsobjektiv nach Anspruch 1. Eine Variante gibt Anspruch 15. Vorteilhafte Ausführungsformen sind Gegenstand der Unteransprüche 2 bis 14 und 16 bis 19.

Gemeinsam ist allen Ausführungen die Verstellung eines gekrümmten, also schon in der Grundstellung für die Bildgebung wirksamen Spiegels, mit wenigen Aktuatoren, die passend zur erforderlichen Deformation des Spiegels angeordnet sind.

Die Teilezahl und der Montage- und Steuerungsaufwand wird so erheblich reduziert und die benötigten Formkorrekturen können formtreuer eingestellt werden als mit einem unspezifischen Aktuator-Array.

Das Betriebsverfahren nach Anspruch 20 löst die Aufgabe, ein entsprechendes verfahren anzugeben und konkretisiert höchstens acht Angriffspunkte der Verstelleinrichtung.

Anspruch 21 beschreibt die vorzugsweise erfaßten und korrigierten Bildfehler, wobei die Messung während der Belichtung oder alternierend dazu im Bereich der Bildebene vorgesehen ist.

Ergänzend oder alternativ ist die Erfassung der Betriebsparameter der Projektionsbelichtungsanlage oder der Eigenschaften der Maske als Parameter zur Steuerung der Deformation vorgesehen. Schon bei der Konstruktion oder bei der Kalibrierung des Systems können dafür die zugehörigen Formeinstellungen festgelegt werden.

Ferner können nach den Ansprüchen 23 bis 24 Linsen, Maske und/oder Wafer zur Verbesserung der Abbildungsqualität verschoben werden

Primär betrifft die Erfindung also die Korrektur von Fehlern, die nicht rotationssymmetrisch' aber auch nicht beliebig verteilt sind, durch eine entsprechende nicht rotationssymmetrische Spiegelverformung. Gerade bei Wafer-Scannern mit schmalem rechteckigem Bildfeld ist dies zur Korrektur der entstehenden nicht rotationssymmetrischen Linsendeformationen angezeigt.

Näher erläutert wird die Erfindung anhand der Zeichnung.
- Figur 1: zeigt schematisch eine Projektionsbelichtungsanlage mit katadioptrischem Reduktionsobjektiv und adaptivem Spiegel;
- Figur 2: zeigt ein Schema der Aktuatoren am Spiegel;
- Figur 3: zeigt schematisch das Bildfeld eines Wafer-Scanners;
- Figur 4: zeigt schematisch im Querschnitt einen adaptiven Spiegel mit Aktuator, Stellglied und mehreren Angriffspunkten.

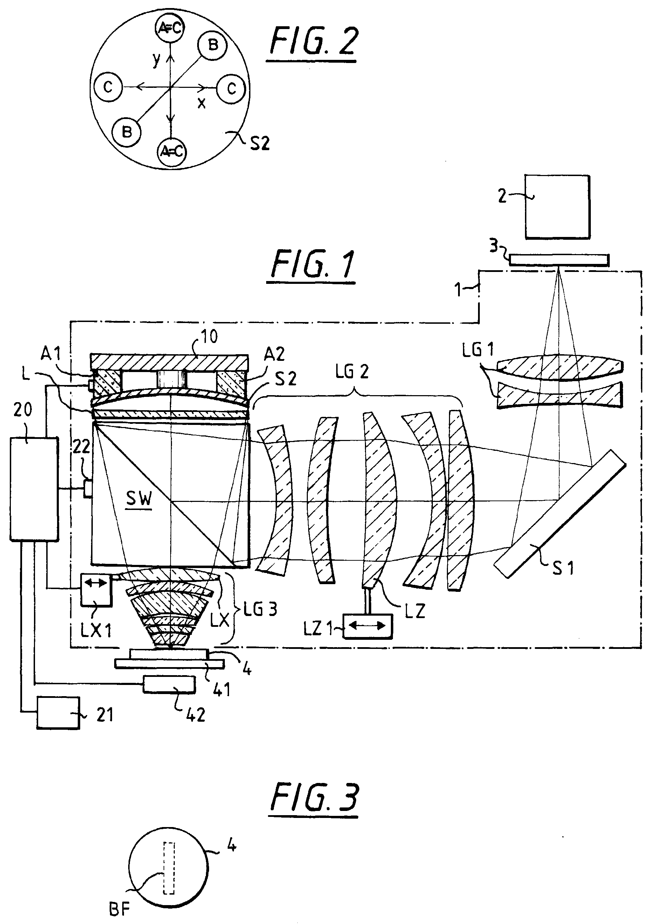

Kernstück der katadioptrischen Projektionsbelichtungsanlage nach Figur 1 ist das katadioptrische Reduktionsobjektiv 1, in dem gezeigten Beispiel die Ausführung nach Figur 1 und Tabelle 1 der Patentanmeldung DE 196 16 922.4 (US Ser. 08/845,384), die hierin inkorporiert sein soll.

Dieses katadioptrische Reduktionsobjektiv 1 umfaßt eine erste Linsengruppe LG1, einen planen Umlenkspiegel S1, eine zweite Linsengruppe LG2, einen Strahlteilerwürfel SW, eine Lambda-Viertel-Platte L, einen gekrümmten Spiegel S2 und eine dritte Linsengruppe LG3. Eine Beleuchtungseinrichtung 2, die Maske 3 und der Wafer 4 auf einem Halter (Wafer-chuck) 41 vervollständigen die insoweit konventionelle Projektionsbelichtungsanlage.

Neu ist der Hohlspiegel S2 als adaptiver Spiegel ausgebildet. Dazu sind Aktuatoren A1, A2 und ein Gestell 10 vorgesehen. Ein Sensor 42, z.B. ein Wellenfrontsensor, ist im Bereich des Wafers 4 vorgesehen, der während der Waferbelichtung oder in Pausen, wenn der Wafer 4 aus dem Strahlengang entnommen ist, ein Maß für die Abbildungsqualität mißt.

Eine Regeleinheit 20 - vorzugsweise eine funktionelle Einheit eines Rechners, der auch weitere Steuer- und Regelaufgaben des Wafer-Steppers oder -Scanners übernimmt - nutzt dessen Signale sowie ggf. die von weiteren Sensoren 21 - z.B. für Luftdruck und Umgebungstemperatur - oder 22 - für die Temperatur des Strahlteilerprismas SW - zur Ansteuerung der Aktuatoren A1, A2 und so zur Regelung der Abbildungsqualität.

Optional können auch achsial verstellbare Linsen - hier die Linse LZ der zweiten Linsengruppe LG2 - und/oder radial verstellbare Linsen - hier die Linse LY - vorgesehen werden und über Stellglieder LZ1, LY1 von der Regeleinheit 20 gesteuert werden.

Durch Verwendung von immer kürzeren Wellenlängen in der Halbleiterlithographie kommt es zu verschiedenen zeitabhängigen Material-Effekten, die die Abbildungsqualität der Belichtungsoptik empfindlich beeinflussen. Hier ist aufgrund der verstärkten Absorption die Aufheizung von Linsengruppen (Lens heating) zu nennen, deren Auswirkung so stark ist, daß die entstehenden Bildfehler samt ihrem zeitverlauf vermessen, bzw. simuliert und dann mit einer Regelschleife abgestimmt werden müssen. Für Wellenlängen unterhalb 248 nm zeigt sich, daß die Absorption in Abhängigkeit der Bestrahlungsstärke und -dauer zunimmt. Die Absorptionszunahme (Induced Absorption) führt zu einem zusätzlichen Lens heating, das wie oben abgestimmt werden muß. Ein weiterer Effekt ist eine kontinuierliche Zunahme der Brechzahl, die mit einer Schrumpfung des Materials einhergeht. Auch dieser Effekt ist strahlungsabhängig und wird Compaction genannt. Auch hier besteht die Anforderung einer dynamischen, aufgrund der langen Zeitskalen jedoch quasistatischen Korrektur der Bildfehler. Besonders große Bildfehler treten durch Lens heating an einem katadioptrischen Design auf, das einen Strahlteilerwürfel SW enthält. Hier ist nach derzeitigem Stand der Materialeigenschaften eine aktive Korrektur von Pupillenfehlern erforderlich.

Vorgeschlagen wird daher ein adaptiver Spiegel L, der mit geeigneten Manipulationsmöglichkeiten A1, A2 ausgestattet ist, um diese Bildfehler, die material- und prozeßbedingt sind, während des Betriebs des Objektivs 1 abzustimmen und so die Abbildungsqualität des Objektivs 1 zu gewährleisten. Der adaptive Spiegel S2 ist notwendig, um bestimmte Bildfehler, wie Astigmatismus auf der Achse, abzustimmen, wenn ansonsten nur sphärische zentrierte Elemente verwendet werden.

Dieser Vorschlag ist für alle katadioptrischen Designs, die einen bildgebenden Spiegel enthalten, verallgemeinerbar. Für alle diese Systeme, insbesondere bei Verwendung eines schlitzförmigen Bildfelds (Scanner) ist die Erwärmung der Objektive nicht rotationssymmetrisch, so daß auf der Achse ein Astigmatismus entsteht.

Insgesamt sind die Hauptbildfehler, die durch Linsenerwärmung (Lens heating) auch in Folge "induzierter" Absorption und durch Compaction des Strahlteilerwürfels entstehen (typische Werte in Klammer):
a1) Astigmatismus auf der Achse (150 nm)
b1) Koma auf der Achse (20 nm)
c1) veränderte Fokuslage (1 µm)
d1) Bildfeldversatz (quer) (100 nm)
e1) Maßstabsfehler (1-5 ppm)
f1) Bildschale (50 nm)
g1) Vierwelligkeit als Pupillenfehler
h1) Sphärische Aberration als Pupillenfehler.

Diese Fehler erreichen den stationären Zustand im Laufe von mehreren Stunden, müssen somit relativ langsam nachgestellt werden.

Da es sich um ein Scanner-System handelt, ist das Bildfeld schlitzförmig (z.B. 8 x 25 mm). Daher treten stark elliptische Beleuchtungsverteilungen in den Linsen auf (insbesondere bei den wafernahen Linsen der Linsengruppe LG3), die folgende Bildfehler zur Folge haben:
a2) Astigmatismus auf der Achse
c2) Veränderte Fokuslage (0,5 µm)
e2) Maßstabsfehler (1-5 ppm)
f2) Bildschale (100 nm).

Die für ein Beamsplittersystem benötigte Lambda-Viertel-Platte steht im 45° Winkel zu den Achsen des Scannerschlitzes. Durch die Halterung der rechteckigen Lambda-Viertel-Platte bedingt, wird aufgrund der Druchbiegung der Platte auch Astigmatismus in 45° Richtung auftreten.
a3) 45° Astigmatisums

### Kompensationsmöglichkeiten sind:

Für a1), g1), a2), a3) : Adaptiver Spiegel, dieser müßte für a1), a2) und a3) mit mindestens vier Aktuatoren Ai ausgestattet sein (0° und 45° Astigmatismus) . Korrigiert man nur den dominanten 0° Astigmatismus, so genügen zwei Aktuatoren Ai. Die Aktuatoren Ai sind paarweise symmetrisch zur optischen Achse anzuordnen.
- g1): braucht, da es sich wegen der Würfelgeometrie nur um eine 0°-Vierwelligkeit handelt, 4 Aktuatoren Ai in vierzähliger Rotationssymmetrie zur optischen Achse, mit kollektiver Ansteuerung. Stellbereich der Aktuatoren: -50 nm bis +50 nm Auflösung und Stabilität: < 1 nm
- b1): ist mit einer Zentrierlinse (Linse LX in diesem Beispiel) mit radialer Beweglichkeit zu kompensieren.
- c1), d1), c2):: Justage des Wafers 4 in achsialer Richtung.
- e1), h1), e2), f2):: Verschieben des Retikels 3 in achsialer Richtung und z-Manipulatoren LZ1 zum Verschieben von einzelnen Linsen LZ oder Linsengruppen in z-Richtung (achsial).

### Zum Messen der Bildfehler:

Bildfeldversatz (d1), Maßstab (e1, e2), Fokuslage (c1, c2), Astigmatismus (a1, a2, a3) und Bildschale (f1, f2) sind im Stepper im Betrieb bestimmbar, z.B. in der in US 5,142,132 angegebenen Weise. Bildfehler höherer Ordnung müssen entweder experimentell vorab bestimmt werden oder simuliert werden (FE-Rechnungen). Dabei ist zu beachten, daß bei Vermessung in Prüfinterferometern oder mit Wellenfrontsensoren hoher Auflösung verschiedene Betriebsmodi des Objektivs (NA, σ, Reticle-Transmission) sich anders verhalten. Das Verhalten muß dann in spezifischen look-up tables im Speicher der Steuereinheit 20 abgelegt werden.

Figur 2 zeigt schematisch in Aufsicht auf den konkaven Spiegel S2 die Lage der Angriffszonen der Aktuatoren Ai am konkaven Spiegel S2 bei einem der Figur 3 entsprechenden schlitzförmigen Bildfeld BF.

Die vier Zonen C, in vierzähliger Rotationssymmetrie auf der x- und y-Achse gelegen, sind geeignet, die Vierwelligkeit zu kompensieren. Dazu werden sie kollektiv angesteuert und deformieren den als elastische Membran ausgeführten Spiegel S2 mit vier zueinander symmetrischen lokalen Extrema. Die genauen Lagen (Radius) der Aktuatoren Ai in den Zonen C, der Verstellweg und die Form der deformierten Fläche, die über deren Elastizität usw. beeinflußt wird, ist dem einzelnen Objektiv 1 und der Dimensionierung des Bildfelds BF anzupassen. Im Rahmen der Optik-Design-Rechnungen und mit Finite-Elemente-Rechnungen wird das realisiert.

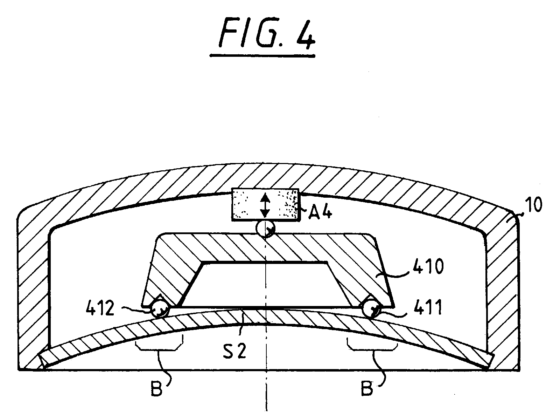

Da alle vier Zonen C kollektiv verstellt werden, ist es möglich, gemäß Figur 4 nur einen Aktuator A4 vorzusehen, der über ein symmetrisches brückenförmiges Stellglied 410 - ausgeführt beispielsweise mit Andruckkugeln 411, 412 zur präzisen momentenfreien Krafteinleitung - den konkaven Spiegel S2 in den Zonen C symmetrisch deformiert. Mit nur zwei Armen könnte das Stellglied 410 auch die zwei Zonen B beeinflussen.

Die in Figur 2 ebenfalls gezeigten Zonen A - zusammenfallend mit zwei der Zonen C - dienen zur Korrektur des Astigmatismus unter 0° zur y-Achse. Die zwei Zonen B unter 45° zur y-Achse dienen zur Korrektur des 45° geneigten Astigmatismus. Auch hier werden die Aktuatoren Ai paarweise zu den Zonen A bzw. B gestellt und es sind der Figur 3 entsprechende Konstruktionen mit Stellelementen möglich.

Zur Astigmatismuskorrektur ist es auch vorteilhaft, an den Zonen A Druck und an den beiden dazu gekreuzten Zonen C Zug auf die Spiegelmembran auszuüben (oder umgekehrt).

Es können wie gezeigt achsiale Kräfte in Richtung der optischen Achse des Spiegels S2 aufgebracht werden, aber auch Kräfte senkrecht dazu - in der Spiegelebene senkrecht zur optischen Achse -, Zwischen- und Mischformen und Momente. Die Aktuatoren können auch am Umfang des Spiegels S2 angreifen.

Die erfinderische Lösung zeigt also besondere Einfachheit, da mit wenigen unabhängigen Aktuatoren gezielt bestimmte wenige optische Fehler beeinflußt werden. Dabei ist an eine echte Regelung gedacht, wie auch an reine Feedforward-Steuerung. Auch ist an die Überkompensation an einem verstellbarem Element gedacht, um Fehlereinflüsse anderer Elemente - irgendwo in der Projektionsbelichtungsanlage - vorzuhalten. Fertigungstoleranzen (Exemplarstreuung), Lens Heating und Compaction, aber auch Brechungsindexänderungen des Füllgases u.a. können kompensiert werden. Zur Reduzierung der Stellwege kann im aktiven Spiegel oder in anderen Teilen des Systems ein Vorhalt vorgesehen werden.

## Patentansprüche

1. Katadioptrisches Projektionsobjektiv der Mikrolithographie mit mindestens einem gekrümmten Spiegel (S2), dadurch gekennzeichnet, daß
- mindestens ein gekrümmter Spiegel (S2) verformbar ist
- Stellelemente (Ai, 41) vorgesehen sind, welche den verformbaren Spiegel (S2) verformen können
- die Stellelemente (Ai, 41) an bestimmte Bildfehler und deren Korrektur angepaßt sind.

2. Katadioptrisches Projektionsobjektiv nach Anspruch 1, dadurch gekennzeichnet, daß genau ein gekrümmter Spiegel (S2) vorhanden ist.

3. Katadioptrisches Projektionsobjektiv nach Anspruch 1 oder 2, dadurch gekennzeichnet, daß ein Stellelement (41) mit einem Aktuator (A4) und zwei Anschlußstellen (B) am verstellbaren Spiegel (S2) vorgesehen ist, bei dem die zwei Anschlußstellen (B) symmetrisch zur optischen Achse des Spiegels (S2) angeordnet sind, und mit dem der Astigmatismus korrigiert wird.

4. Katadioptrisches Projektionsobjektiv nach mindestens einem der Ansprüche 1-2 oder Anspruch 3, dadurch gekennzeichnet, daß ein zweites Stellelement mit einem zweiten Aktuator und vier Anschlußstellen (C) am verstellbaren Spiegel (S2) vorgesehen ist, bei dem die vier Anschlußstellen (C) in vierzähliger Symmetrie zur optischen Achse des Spiegels (S2) angeordnet sind.

5. Katadioptrisches Projektionsobjektiv nach mindestens einem der Ansprüche 1-4, dadurch gekennzeichnet, daß
- mindestens ein Sensor (42) vorgesehen ist, der von dem projizierten Bild beeinflußt wird, und
- ein Steuersystem (20), welches den mindestens einen Sensor (42) und die Stellelemente (Ai) zu einem Regelkreis verknüpft, in dem Bildfehler minimiert werden.

6. Katadioptrisches Projektionsobjektiv nach mindestens einem der Ansprüche 1-5, dadurch gekennzeichnet, daß
- mindestens ein zweiter Sensor (21, 22) vorgesehen ist, und
- ein Steuersystem (20), welches mindestens einen zweiten Sensor (21, 22) und die Stellelemente (Ai, 410) zu einem Regelkreis verknüpft, in dem Bildfehler minimiert werden.

7. Katadioptrisches Projektionsobjektiv nach Anspruch 5, dadurch gekennzeichnet, daß der Sensor (42) ein Wellenfrontsensor ist.

8. Katadioptrisches Projektionsobjektiv nach Anspruch 5, dadurch gekennzeichnet, daß der Sensor (42) eine Kamera, insbesondere eine CCD-Kamera ist.

9. Katadioptrisches Projektionsobjektiv nach mindestens einem der Ansprüche 1-8, dadurch gekennzeichnet, daß ein Sensor (21, 22) Zeit, Temperatur, Druck, eine Strahlungsgröße, oder die Zahl der Lichtpulse oder der Belichtungen erfaßt.

10. Katadioptrisches Projektionsobjektiv nach mindestens einem der Ansprüche 1-9, dadurch gekennzeichnet, daß zusätzlich mindestens ein optisches Element (LZ, LX) lageveränderlich ist.

11. Katadioptrisches Projektionsobjektiv nach Anspruch 10, dadurch gekennzeichnet, daß die Lage achsial in Richtung der optischen Achse veränderlich ist oder der optische Weg variabel ist.

12. Katadioptrisches Projektionsobjektiv nach Anspruch 10 oder Anspruch 11, dadurch gekennzeichnet, daß die Lage transversal zur optischen Achse veränderlich ist.

13. Katadioptrisches Projektionsobjektiv nach mindestens einem der Ansprüche 10-12, dadurch gekennzeichnet, daß die Lage rotatorisch um die optische Achse veränderlich ist.

14. Katadioptrisches Projektionsobjektiv nach mindestens einem der Ansprüche 1-13, dadurch gekennzeichnet, daß ein oder mehrere Stellelemente (Ai, 42) einen oder mehrere Aktuatoren (Ai) aufweisen, deren Form und Anordnung an die Form der Deformation des Spiegels (S2) angepaßt sind.

15. Katadioptrisches Projektionsobjektiv der Mikrolithographie mit mindestens einem gekrümmten Spiegel (S2), dadurch gekennzeichnet, daß
- mindestens ein gekrümmter Spiegel (S2) verformbar ist,
- die Verformbarkeit Formen des Spiegels (S2) umfaßt mit zwei- oder vierzähliger Rotationssymmetrie oder mit Rotationssymmetrie oder Überlagerungen von Formen mit den genannten Symmetrien,
- Aktuatoren (Ai) oder durch Aktuatoren (Ai) betätigte Stellelemente (410) vorgesehen sind zur Verformung, deren Zahl, Form und Lage der Krafteinleitung zur Verformung des Spiegels (S2) den Formen des Spiegels (S2) und deren Symmetrie angepaßt ist.

16. Katadioptrisches Projektionsobjektiv nach mindestens einem der Ansprüche 1-15, dadurch gekennzeichnet, daß der Spiegel (S2) in seiner Grundform rotationssymmetrisch ist und einen mit dem Radius monoton wachsenden Gradienten in radialer Richtung aufweist.

17. Katadioptrisches Projektionsobjektiv nach Anspruch 15 oder Anspruch 16, dadurch gekennzeichnet, daß vier Aktuatoren (A1-A4) oder Angriffspunkte von Stellelementen (410) vorgesehen sind, welche der Grundform eine Vierwelligkeit mit vierzähliger Rotationssymmetrie zur optischen Achse überlagern können.

18. Katadioptrisches Projektionsobjektiv nach mindestens einem der Ansprüche 1-16, dadurch gekennzeichnet, daß sechs Stellen vorhanden sind, an denen ein Aktuator (Ai) oder ein Stellelement (410) an den Spiegel (S2) angreift, wovon vier (C) in vierzähliger Symmetrie angeordnet sind und paarweise synchronisiert sind und die restlichen zwei (B) in zweizähliger Symmetrie auf einer Winkelhalbierenden zwischen den vier Aktuatoren (A1-A4) oder Stellelementen angeordnet sind.

19. Katadioptrisches Projektionsobjektiv nach mindestens einem der Ansprüche 1-18, dadurch gekennzeichnet, daß Aktuatoren (Ai) oder durch Aktuatoren (Ai) betätigte Stellelemente (410) in Richtung der optischen Achse des Spiegels (S2) oder senkrecht dazu wirken.

20. Die Abbildungsqualität steigerndes Betriebsverfahren einer Mikrolithographie-Projektionsbelichtungsanlage mit einem katadioptrischen Projektionsobjektiv (1) mit mindestens einem gekrümmten Spiegel (S2) bei dem ein gekrümmter Spiegel (S2) deformiert wird durch Aktuatoren (Ai) oder Stellglieder (410) mit höchstens vier, vorzugsweise drei Paar Angriffspunkten (A, B, C).

21. Verfahren nach Anspruch 20, dadurch gekennzeichnet, daß während der Belichtung oder alternierend damit im Bereich der Bildebene (4) Bildfeldversatz, Maßstab, Fokuslage, Astigmatismus und/oder Bildschale erfaßt werden und die Aktuatoren (Ai) oder Stellglieder (410) abhängig davon angesteuert werden.

22. Verfahren nach Anspruch 20 oder Anspruch 21, dadurch gekennzeichnet, daß Betriebsparameter der Projektionsbelichtungsanlage, besonders die numerische Apertur des Projektionsobjektivs (1), Art und Kohärenzgrad der Beleuchtung (2), und/oder Eigenschaften der Maske (3), insbesondere deren mittlere Transmission, erfaßt werden und die Aktuatoren (Ai) oder Stellglieder (410) abhängig davon angesteuert werden.

23. Verfahren nach mindestens einem der Ansprüche 20-22, dadurch gekennzeichnet, daß zusätzlich mindestens eine Linse (LZ, LY) bewegt wird, insbesondere entlang der optischen Achse verschoben, um diese gedreht oder senkrecht dazu verschoben wird.

24. Verfahren nach mindestens einem der Ansprüche 20-23, dadurch gekennzeichnet, daß die Maske (3) oder der Wafer (4) in ihrer Lage verändert werden.

25. Verfahren nach mindestens einem der Ansprüche 20-24, dadurch gekennzeichnet, daß Lens Heating und/oder Compaction, vorzugsweise zugleich, kompensiert werden.

26. Verwendung eines Projektionsobjektivs nach mindestens einem der Ansprüche 1-19 für ein Verfahren nach mindestens einem der Ansprüche 20-25.
